(19)

Europäisches Patentamt

European Patent Office

Office européen des brevets

(11) **EP 3 287 804 A1**

(12) **EUROPEAN PATENT APPLICATION**

(43) Date of publication:
**28.02.2018 Bulletin 2018/09**

(51) Int Cl.:
***G01R 33/3415*** (2006.01)   ***G01R 33/36*** (2006.01)

(21) Application number: **16001855.2**

(22) Date of filing: **24.08.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Universität Heidelberg**
**69117 Heidelberg (DE)**

(72) Inventor: **Chacon-Caldera, Jorge**
**68159 Mannheim (DE)**

(74) Representative: **Müller-Boré & Partner**
**Patentanwälte PartG mbB**
**Friedenheimer Brücke 21**
**80639 München (DE)**

(54) **MRI-ANTENNA AND METHOD FOR PROVIDING MR-IMAGES**

(57)   A magnetic resonance imaging-antenna (1; 2; 3; 4; 5; 6) comprises a first coil (10) comprising a first planar section (11) defining a first detection area (14), wherein the first planar section (11) is arranged within a first plane, and a second coil (20; 30) comprising a second planar section (21; 31) defining a second detection area (24; 34), wherein the second planar section (21; 31) is arranged within a second plane. Therein, the first coil (10) comprises a first bent section (12) that is bent out of the first plane of the first planar section (11).

Fig. 1A

EP 3 287 804 A1

## Description

The invention relates to a magnetic resonance imaging antenna and to a use of at least one magnetic resonance imaging antenna to detect magnetic resonance signals.

Magnetic resonance imaging, abbreviated as MRI, is a well established imaging technique, in particular a medical imaging technique used in radiology to image the anatomy and the physiological process of the body in both health and disease. MRI is based upon the science of nuclear magnetic resonance. Therein, nuclear spin energy transitions are excited and registered by MRI-antennas. The MRI-antennas are usually provided as coils (also known as resonators) that register electromagnetic energy emitted by the imaged sample and/or body.

Resonators for signal reception in magnetic resonance are traditionally built planar in order to restrict coil material and to avoid coil losses that increase with the length of the coil loops. Magnetic resonance images show artefacts and/or noise reducing the quality of the detected images. In order to increase the quantity of the imaging process, in particular in order to increase the SNR (abbreviation for signal to noise ratio), overlapping coils are arranged to increase the quality of the images which may be used, e.g., to increase the image resolution. However, these tightly packed and/or arranged coils may interact and/or interfere with each other.

Signal to noise ratio is a key factor in magnetic resonance imaging. SNR may limit the minimum scanning times and applications, the maximum resolution, and may also determine the diagnostic quality of the images. The maximum SNR is limited by the MRI system, the measurement setup and the signal reception elements. For a given setup and system, increasing SNR at a region of interest (abbreviated as ROI) is increasingly challenging as the depth of the ROI increases. The challenge is present even in innovative approaches such as the use of metamaterials which focus the sensitivity field but obtain maximum SNR gains from objects near the coil i.e. superficial areas of the sample. This is due to the exponential decrease in sensitivity of the reception elements as the distance from the coil increases. The optimization of reception elements for MRI is necessary to maximize SNR especially for deep tissues in the sample.

Historically, one of the main priorities in the design of reception elements for MRI has been to fit the elements to the imaged volume tightly. In typical approaches, since the early 90s, this is done using small planar or approximately planar elements that are located around the surface of the sample regardless of the application. Their purpose is to maximize the detected signal arising from the sample-volume while the noise arising from the coil resistance is minimized. Practically, this is achieved by making the whole elements sensitive to the signal and minimizing both the coil conductor material and lumped elements to reduce losses. This has been thus far considered ideal since the effective resistance of the MRI experiment includes the coil resistance $R_{coil}$ as:

$$R_{eff} = R_{sample} + R_{coil} + R_{electronics}$$

A problem relates to increasing the quality of magnetic resonance imaging, in particular to increasing the SNR in MRI.

This problem is solved by the subject-matter of the independent claims. Preferred embodiments are the subject-matter of the dependent claims.

An aspect relates to a magnetic resonance imaging antenna comprising a first coil and a second coil. The first coil comprises a first planar section defining a first detection area, wherein the first planar section is arranged within a first plane. The second coil comprises a second planar section defining a second detection area, wherein the second planar section is arranged within a second plane. Herein, the first coil comprises a first bent section that is bent out of the first plane of the first planar section.

The magnetic resonance imaging antenna, abbreviated as MRI-antenna, may be implemented as a combination of a plurality of coils, in particular of coils arranged at a predetermined distance from each other and/or at a predetermined orientation with respect to each other. The MRI-antenna may comprise at least two geometrically decoupled coils as resonators.

The first planar section of the first coil may consist of parts of the winding of the first coil. The first planar section may be completely arranged within the first plane. Thus, the first detection area is also arranged within the first plane, in particular as part of the first plane. Also the second detection area of the second planar section may be provided completely within the second plane. The respective planar section of the respective coil may define the respective detection area by covering said detection area, and/or by at least partially limiting and/or confining the respective detection area. The planar sections of the first coil and the second coil may be arranged substantially parallel to each other and/or substantially parallel to a surface of the sample to be imaged. In other words, the planar sections substantially cover the sample at least partially. The first and/or second planes may be arranged substantially perpendicular to a mean emission direction originating from the sample towards the MRI-antenna. The arrangement of the first and second detection areas define in which direction the sensitivity of the respective coil is directed.

The first and the second coil may be arranged in close vicinity of each other, in particular at least partially overlapping. Therefore, also their respective detection areas may overlap at least partially. This may result in interference and/or mutual interaction of adjoining sections of the two different coil loops. By providing the first coil with the bent section that is bent out of the first plane, this interference may be reduced. By reducing the interference, the imaging quality is increased, in particular the SNR may be increased.

The first bent section may be bent out of the first plane in a direction leading away from the second planar section. In particular, the first bent section may be bent in a direction leading away from the sample to be imaged, thus enabling an arrangement of the first planar section in close vicinity of the imaged sample without significant disturbance provided by the first bent section.

The first bent section of the first coil may be bent at a predetermined angle with respect to the first plane. For example, the bent section of the first coil may be bent at an angle of between about 30° and about 150°, in particular at an angle of between about 60° and about 120°, preferably at about 90°. Thus, sections of the two coils that may lead to interference and/or mutual interaction are spaced apart. While this may increase the material usage of the first coil, the overall signal to noise ratio may still be increased. Even though it is a common goal in MRI to reduce the total material usage of the coils to reduce signal losses, the overall SNR may still be increased by the implementation of the first bent section.

The first coil and/or the second coil may, e.g., be provided as a single loop coil or as a butterfly coil.

Here, the first planar section and the first bent section may be part of the same coil loop, e.g. they may form and/or provide a coil loop of the first coil together.

Thus, the properties of the coils may be modified to optimize the physically available planar space despite a reduction in sensitivity by increased material usage.

According to an embodiment, the first bent section at least partially adjoins and/or overlaps the second detection area. In other words, the first bent section is arranged in close vicinity to the second detection area, so that interference and/or mutual interaction may occur if the first bent section would not be bent out of the first plane. However, by bending that first bent section out of the first plane, the SNR may be increased. Herein, the terms "adjoin" and "overlap" may refer to a substantially perpendicular projection onto the second planar section and/or the first planar section. In this two-dimensional projection of the first bent section onto the second plane in which the second planar section is arranged, the projection of the first bent section may adjoin the second detection area. The term 'adjoining' may relate to a maximum distance of up to about 2 cm, preferably up to about 5 mm, more preferably up to about 2 mm, more preferably up to about 500 $\mu$m, e.g. at a minimum distance of about 100 $\mu$m. In said projection, the first bent section may also at least partially overlap the second detection area, meaning it may be arranged on top and/or below of the second detection area. Such a close vicinity of the sections would result in interference and/or interaction in case the first bent section would not be bent out of the first and/or second plane. Thus, bending at least one section of the first coil that is (at least in the projection) in close vicinity to sections of the second coil out of the first/second plane increases the SNR.

According to an embodiment, the first planar section at least partially overlaps the second planar section so that the first detection area at least partially overlaps the second detection area. The first detection area and the second detection area may substantially be part of a common detection area. The first planar section and the second planar section may occupy substantially the same area and/or may substantially overlap entirely. Herein, the first detection area and the second detection area may be arranged substantially parallel to each other and even slightly spaced apart from each other, e.g. above or below each other, to avoid direct physical contact of the two coils. The first coil and the second may be provided to detect magnetic resonance in the two detection areas that overlap at least partially when viewed upon in the mean emission direction from the sample towards the two detection areas. Providing substantially overlapping planar coils increases the resolution/sensitivity and, thus, the quality of the magnetic resonance imaging. This fact is used to increase the quality of the imaging process. However, whenever planar sections of coils are overlapping, some sections of said coils are arranged in close vicinity of each other, which may result in interference and/or mutual interaction. Thus, providing at least one of said coils as partially bent coil may reduce said mutual interaction and increase the overall quality of the imaging process.

According to an embodiment, the first bent section is bent substantially orthogonal to the first planar section. The first bent section may not primarily be used for signal detection. Thus, the first bent section is arranged at an angle that minimizes interference between the first bent section of the first coil and the second planar section of the second coil. Also, arranging the first bent section substantially planar reduces the required space within the first plane and, thus, increases the freedom of the design within the first plane.

According to an embodiment, the second coil comprises a second bent section that is bent out of the second plane of the second planar section. The second bent section may be bent similar as the first bent section. The second bent section may not primarily be used for signal detection. By providing both coils with at least one bent section each, the overall sensitivity and signal to noise ratio may be further increased. The second bent section may be bent at an angle of between 30° and 150°, preferably between 60° and 120°, even more preferably at an angle of substantially 90° to the second plane. The two bent sections of the first coil and the second coil may be bent out of the detection plane towards the same side, thereby reducing the required space. However, the bent sections may be bent towards opposing sides, thereby limiting interference between the bent sections of the respective coils. In particular, the first bent section and the second bent section may be both bent in a direction leading away from the sample to be imaged, thus enabling an arrangement of the first and second planar sections in close vicinity of the imaged sample without significant disturbance provided by the bent sections. The MRI-antenna may comprise a third planar and/or orthogonal coil including but not limited to butterfly, figure-8, Helmholtz, dipole, and composite for quadrature detection.

According to an embodiment, in an orthogonal projection onto the first plane, the first bent section is spaced from the second planar section less than 2 cm. At a coil distance of less than 2 cm, in particular of less than 5 mm and/or less than 2 mm, interference and mutual interaction become significant. Thus, bending the section(s) of the first coil out of the first plane that may cause significant interference increases the SNR. Herein, all sections of the two coils that are spaced (in a projection onto the first and/or second plane) from the respective other planar section less than about 2 cm may be bent. For example, at a first end of the MRI-antenna at which the two coils are arranged in close vicinity, the first bent section may be provided. At a second end of the MRI-antenna at which the two coils are arranged in close vicinity, a second bent section of the second coil may be provided, and/or another bent section of the first coil. Thus, any significant mutual interaction between the coils may be reduced.

According to an embodiment, the first bent section is arranged at an area of destructive interference originating from a close proximity of the first coil and the second coil. Destructive interference may occur at intersections of the two respective coils comprising substantially opposite current flow directions. Thus, a close proximity of such sections of the two coils may significantly increase interference. This embodiment may reduce said destructive interference between the two coils.

In an embodiment, the first bent section of the first coil defines the first substantially orthogonal area of the first coil arranged at a first bent side of the first detection area. The second coil comprises a second bent section that is bent out of the second plane of the second planar section. The second bent section defines a second substantially orthogonal area of the second coil arranged at a second bent side of the second detection area.

Here, the first coil is provided in two areas, namely the first detection area and the first orthogonal area. The first orthogonal area is arranged substantially orthogonal to the first plane. While the first planar section of the first coil is arranged within the first plane, the first bent section of the first coil is arranged within the first orthogonal area. In other words, all of the first bent section may be arranged within a single plane, namely the first orthogonal plane in which the first substantially orthogonal area is arranged. The orthogonal arrangement of the first bent section is in particular advantageous because thus the first bent section does not interfere with the planar sections that define the sensitivity of the coils.

Since the whole first bent section is arranged within a single plane, namely the first orthogonal plane, a line of intersection of the first plane and the first orthogonal area is provided as a line and/or an edge of the first detection area. This line of intersection is provided by the first bent side at which the first planar section transitions into the first bent section. In other words, the first detection area may be limited and/or confined at all sides by either the first planar section or by the first bent side. The first bent side is provided by a substantially orthogonal projection of the first bent section onto the first plane.

In this embodiment, not only the first coil comprises the first bent section, but also the second coil comprises the second bent section. As in the first coil, also the second bent section defines the second substantially orthogonal area that is arranged substantially orthogonal to the second plane. "Defining" means that the respective bent section limits and/or covers said respective orthogonal area. In other words, each of the coils is partially vertically arranged and, thus, provides a decoupling of stacked coils for MRI-antennas.

Also the whole second bent section is arranged within a single plane, namely the second orthogonal plane. A line of intersection of the second plane and the second orthogonal area is provided as a line and/or an edge of the second detection area. This line of intersection is provided by the second bent side at which the second planar section transitions into the second bent section. In other words, the second detection area may be limited and/or confined at all sides by either the second planar section or by the second bent side. The second bent side is provided by a substantially orthogonal projection of the second bent section onto the second plane.

According to a further development of this embodiment, the first bent side is at least partially adjoining the second detection area at a side opposite of the second bent side and/or the second bent side is at least partially adjoining the first detection area at a side opposite of the first bent side. The first bent side may be arranged parallel to the second bent side. As before, 'adjoining' means that the sides have a distance of at most about 2 mm of each other in the first and/or second plane.

Herein, the two detection areas may be substantially rectangular shaped. These two rectangular shaped detection areas may be arranged overlapping and so that the four sides of the rectangular areas are parallel to each other, respectively. Thus, the detection areas may comprise sides in close vicinity of a side of the other detection area. In particular, two opposite sides of each detection area may be arranged in close vicinity of two opposite sides of the other detection area, e.g. partially overlapping. In this particular embodiment, such a side that is arranged in close vicinity of a side of the other detection area is provided as the bent side of the respective detection area. In other words, the bent section of the respective coil is arranged at a side of the coil that is arranged in close vicinity to (e.g. partially overlapping) another coil. Here, the bent sides may be substantially parallel to each other, but spaced apart from each other by the first and/or second detection area arranged between the two bent sides. This arrangement of the two coils may show an increased SNR.

According to an alternative further development, the first bent side is arranged parallel to the second bent side so that the first detection area at least partially overlaps the second detection area and the first orthogonal area at least partially overlaps the second orthogonal area. Here, the first bent side and the second bent side may be arranged substantially on top of each other, e.g. aligned. The overlap of the two detection areas may be provided in a detection plane and/or a detection area of the MRI-antenna. The overlap of the two orthogonal areas may be provided in a common orthogonal plane.

Both the first and the second coil may be provided as a single loop coil. Herein, each single loop coil may comprise a single loop only or it may comprise multiple lobes arranged next to each other, all shaped identically and, thus, forming the single loop of the respective coil.

According to an embodiment, the first coil is provided as a single loop coil. However, a second coil is provided as a butterfly or figure-8 coil. Herein, the second bent side is arranged at the intersection of the butterfly coil so that a (first) planar wing of the butterfly coil is arranged as the second planar section and a (second) bent wing of the butterfly coil is arranged as the second bent section. Butterfly coils may be used in MRI as, e.g., quadrature coils. Butterfly coils may be shaped like an 'eight' comprising an intersection of the coil loop arranged substantially at the center between two 'wings'. Common butterfly coils are usually provided as substantially planar coils. However, the second coil of the MRI-antenna is not provided as a planar coil but comprises only one planar arranged wing, while the other wing is arranged in the second orthogonal area. In other words, the second coil is bent at its centre, near or at the intersection of the butterfly coil. Therefore, mainly the planar wing of the second coil is used to receive magnetic resonance. In this embodiment, the first bent side and the second bent side may be arranged substantially on top of each other. The first bent side of the first coil may also be arranged at the intersection of the second coil. The two coils may be arranged on top of each other so that the two planar sections induce constructive interference, while the sections that induce destructive interference may be bent up. Thus, the area of the two coils inducing destructive interference is bent out of the detection area of the MRI-antenna.

In a further development of this embodiment, a third coil is provided as a single loop coil comprising a third planar section defining a third detection area, wherein the third planar section is arranged within a third plane. The third coil comprises a third bent section that is bent out of the third plane of the third planar section. The third bent section defines a third substantially orthogonal area of the third coil arranged at a third bent side of the third detection area. Herein, the third bent side is arranged parallel to the first and second bent side so that the third detection area is at least partially overlapping the first and second detection area. The third orthogonal area may at least partially overlap the first and second orthogonal area. Here, all three orthogonal areas may be arranged in the same orthogonal plane. Also all three detection areas may be arranged in substantially the same detection plane. Both the first bent side and the third bent side may be arranged at the second bent side of the butterfly coil. Here, also the first detection area and the third detection area may at least partially overlap. Thus, there may be provided at least one area within the detection plane in that all three detection areas overlap. This specific coil arrangement has shown a significant increase of the SNR.

According to an embodiment, the first plane and the second plane are arranged substantially in parallel. The first planar section and the second planar section are responsible for the sensitivity of the respective coil. Thus, they may be arranged so that they face the sample to be imaged. Both the first and the second plane may be substantially arranged in the same planar plane, except for a minimum distance to avoid direct physical and/or electrical contact. Thus, the the first and the second plane may be arranged parallel to the planar plane that may be arranged substantially perpendicular to emissions originating, e.g., from the centre of the sample.

An aspect relates to a plurality of the MRI-antennas according to the first aspect arranged in an array. The array may comprise rows and/or columns of the MRI-antennas. All the detection areas of the MRI-antennas may be arranged substantially within a single plane. However, in an alternative embodiment, the plurality of MRI-antennas may be arranged differently, e.g. in a circle, in particular in a circle around the sample to be imaged.

One aspect relates to the use of one of the MRI-antennas according to the first aspect to detect magnetic resonance for providing a magnetic resonance image. Here, either a single one of the MRI-antennas may be used or a plurality of MRI-antennas, e.g. MRI-antennas arranged in an array.

One aspect relates to a method for providing magnetic resonance images by detecting magnetic resonance by at least one MRI-antenna. The method comprises the steps:

- arranging a first planar section defining a first detection area of a first coil of the MRI-antenna within a first plane,
- arranging a second planar section defining a second detection area of a second coil of the MRI-antenna within a second plane; and
- arranging a first bent section of the first coil so that the bent section is bent out of the first plane of the first planar section.

The method may be carried out with a MRI-antenna according to the first aspect. The method may comprise the step of adapting the size of at least one coil of the MRI-antenna to a predetermined target depth.

Embodiments of the invention are described with reference to the figures. Features of the embodiments shown in the figures may be combined with each other and/or further embodiments. Identical reference numbers identify identical or similar features of the embodiments. The embodiments as shown by:

Fig. 1A     a schematic representation of a planar MRI-antenna and a partially orthogonal MRI-antenna;

Fig. 1B     a schematic representation of a first coil of the partially orthogonal MRI-antenna;

Fig. 1C     a schematic representation of a second coil of the partially orthogonal MRI-antenna;

Fig. 2     a schematic representation of a planar MRI-antenna and a partially orthogonal MRI-antenna;

Fig. 3     a schematic representation of a planar MRI-antenna including a butterfly coil and a partially orthogonal MRI-antenna including a butterfly coil;

Fig. 4     a schematic representation of a partially orthogonal MRI-antenna comprising three coils;

Fig. 5     SNR maps and SNR ratios acquired from phantom MRI measurements;

Fig. 6     in vivo brain scans of a volunteer with GRAPPA as a parallel imaging data acquisition;

Fig. 7     a schematic representation of two partially orthogonal MRI-antennas for quadrature signal detection; and

Fig. 8     a schematic representation of two arrays of partially orthogonal MRI-antennas.

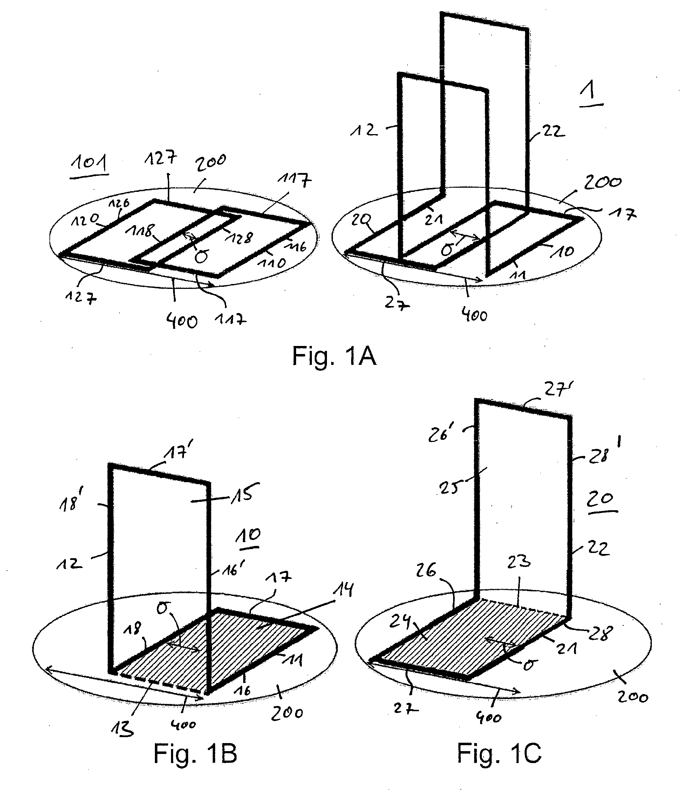

**Fig. 1A** shows a schematic representation of a planar MRI-antenna 101 at the left side and a schematic representation of a partially orthogonal MRI-antenna 1 at the right side.

At the left side of Fig. 1A, a planar MRI-antenna 101 commonly used in magnetic resonance imaging is shown that comprises a first planar coil 110 overlapping a second planar coil 120. Herein, the two coils 110, 120 are provided as single loop coils that are decoupled by an overlap. Both planar coils 110, 120 are provided as substantially rectangular coils comprising a similarly shaped and sized coil cross-section. Alternatively, the MRI-antenna 101 may comprise circular coils. Each of the four sides of the first planar coil 110 is substantially parallel to one side of the second planar coil 120. The two coils 110, 120 are substantially arranged in the same planar plane.

The first planar coil 110 comprises a first overlapping side 118 that almost completely overlaps the coil cross-section of the second planar coil 120. The second planar coil 120 comprises a second overlapping side 128 that almost completely overlaps the coil cross-section of the first planar coil 110. The two overlapping sides 118, 128 are aligned substantially parallel to each other. Also, the first overlapping side 118 comprises the smallest mean distance from the center of the second planar coil 120 of all the sides of the first planar coil 110. Similarly, the second overlapping side 128 comprises the smallest mean distance from the center of the first planar coil 110 of all the sides of the second planar coil 120.

The side of the first planar coil 110 that is arranged opposite of the first overlapping side 118 does not overlap the second coil 120 at all and may be called opposite first side 116. Similarly, the side of the second planar coil 120 that is arranged opposite of the second overlapping side 128 does not overlap the first coil 110 at all and may be called opposite second side 126.

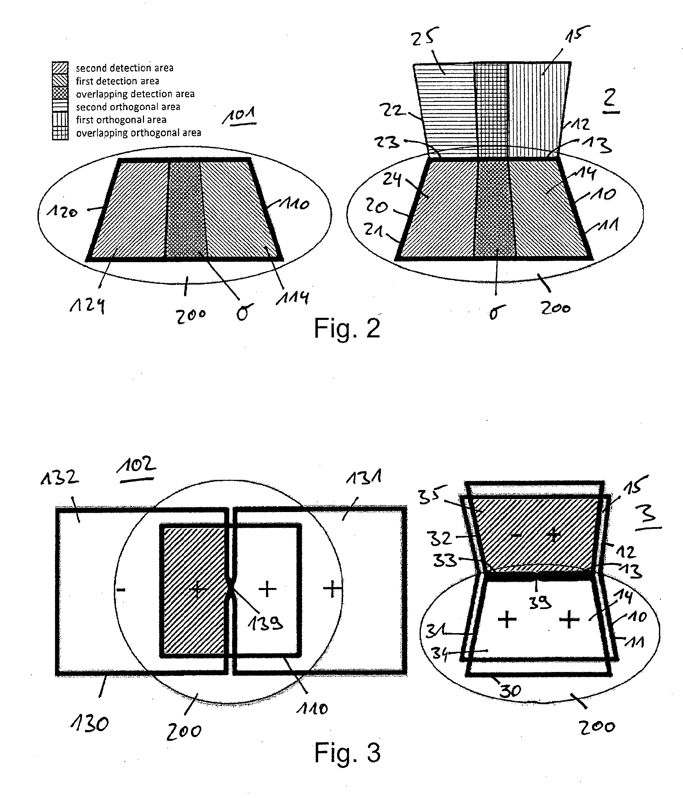

The two other sides of the first planar coil 110 that are arranged adjacent to the first overlapping side 118 overlap the second planar coil 120 partially, namely at the end adjoining the first overlapping side 118. These two partially overlapping sides 117 of the first planar coil 110 are arranged in close vicinity of two partially overlapping sides 127 of the second planar coil 120 that are arranged adjacent to the second overlapping side 128 and that overlap the first planar coil 110 partially, namely at the end adjoining the second overlapping side 128. The overlapping ends of the partially overlapping sides 117, 127 may be arranged within the coil cross-section of the coil they are overlapping, in close vicinity of the coil cross section, or even above the respective other partially overlapping side of the other coil (as shown in Fig. 2).

An overlap area O of the two coils 110, 120 is marked by an arrow with the reference sign O. The two planar coils 110, 120 of the planar MRI-antenna 101 cover a total detection area 400 comprising the area that each individual planar coil 110, 120 covers solely without the overlapped area O, namely the area between the first opposite side 116 and the second opposite side 126. The total detection area 400 is part of a surface of a scan-volume 200 which the MRI-antenna 101 is used to image. The total detection area 400 corresponds to the total planar area occupied by the two planar coils 110, 120 of the planar MRI-antenna 101 minus the overlapped area O.

At the right side of Fig. 1A, a partially orthogonal MRI-antenna 1 is shown that comprises a first coil 10 overlapping a second coil 20. Herein, the two coils 10 and 20 are provided as partially orthogonal single loop coils that are decoupled by an overlap O. The partially orthogonal MRI-antenna 1 is, according to the invention, proposed to substitute the planar MRI-antenna 101. While the partially orthogonal MRI-antenna 1 substantially covers the same detection area 400 as the planar MRI-antenna 101, the partially orthogonal MRI-antenna 1 provides an increased SNR.

**Fig. 1B** shows a schematic representation of the first coil 10 of the partially orthogonal MRI-antenna 1 without the second coil 20. The first coil 10 is provided as partially orthogonal single loop coil comprising a first planar section 11 and a first bent section 12. The first planar section 11 comprises three substantially straight sides arranged within a first planar plane. The substantially straight sides of the first planar section 11 define a first detection area 14 that is shown as a shaded area in Fig. 1B. The first detection area 14 is substantially rectangular and substantially matches the coil cross-section of the first planar coil 110 shown at the left of Fig. 1A.

**Fig. 1C** shows a schematic representation of the second coil 20 of the partially orthogonal MRI-antenna 1 without the first coil 10. The second coil 20 is also provided as partially orthogonal single loop coil comprising a second planar section 21 and a second bent section 22. The second planar section 21 comprises three substantially straight sides arranged within a second planar plane. The substantially straight sides of the second planar section 21 define a second detection area 24 that is shown as a shaded area in Fig. 1C. The second detection area 24 is substantially rectangular and substantially matches the coil cross-section of the second planar coil 120 shown at the left of Fig. 1A.

Fig. 1B shows that the first planar section 11 comprises a first overlapping side 18 that almost completely overlaps the coil cross-section of the second planar section 21 of the second coil 20 (see Fig. 1A, right, and Fig. 1C). The second planar section 21 comprises a second overlapping side 28 that almost completely overlaps the coil cross-section of the first planar section 11 (see Fig. 1 C). The two overlapping sides 18, 28 are aligned substantially parallel to each other and are spaced apart from each other by the overlap O.

The first overlapping side 18 comprises the smallest mean distance (of all the sides of the first planar section 11) from the center of the second planar section 21. Similarly, the second overlapping side 28 comprises the smallest mean distance (11 of all the sides of the second planar section 21) from the center of the first planar section. The overlapping sides 18, 28 are the sides of the respective detection areas 14, 24 that face and/or are arranged closest to the respective center of the respective other detection area 24, 14.

The side of the first planar section 11 that is arranged opposite of the first overlapping side 18 does not overlap the second planar section 21 at all and may be called opposite first side 16. Similarly, the side of the second planar section 21 that is arranged opposite of the second overlapping side 28 does not overlap the first planar section 11 at all and may be called opposite second side 26.

The side of the first planar section 11 that is arranged between the first overlapping side 18 and the first opposite side 16 overlaps the second planar section 21 partially, namely at its end that adjoins the first overlapping side 18. Similarly, the side of the second planar section 21 that is arranged between the second overlapping side 28 and the second opposite side 26 overlaps the first planar section 11 partially, namely at its end that adjoins the second overlapping side 28.

The three substantially straight sides 16, 17, and 18 of the first planar section 11 are provided by a lobe of the first coil 10. The three sides 16, 17, and 18 are substantially identical to the opposite side 116, one of the partially overlapping sides 117, and to the overlapping side 118 of the first planar coil 110 at the left of Fig. 1A. The first detection area 14 is substantially rectangular and limited by said three substantially straight sides 16, 17, and 18 of the first planar section 11 and a first bent-side 13 marked by a dashed line in Fig. 1B. The first bent-side 13 may not be provided by and substantial feature, e.g., a lobe, of the first coil 10, but may be provided at a bending of the first coil 10. The first bent-side 13 is arranged at the transition from the first planar section 11 to the first bent section 12. Also, the first bent-side 13 may be provided by an orthogonal projection of the first bent section 12 onto the first plane in which the first planar section 11 is arranged.

Fig. 1B shows that substantially all parts of the first bent section 12 of the first coil 10 are arranged within a first orthogonal plane. Thus, the first bent section 12 defines a first orthogonal area 15 of the first coil 10. The first orthogonal area 15 is limited by lobes of the first bent section 12 of the first coil 10 that are aligned substantially orthogonal to the first plane. The whole loop of the first coil 10 is provided by the first planar section 11 and the first bent section 12. Thus, the whole loop of the first coil 10 is arranged within the first planar plane and the first orthogonal plane.

The first bent section 12 comprises a first upper side 17' that is arranged at the opposite side of the first bent-side 13. A first overlapping bent side 18' of the first bent section 12 substantially completely overlaps the second coil 20. The first overlapping bent side 18' electrically and physically connects the first overlapping side 18 with the first upper side 17'. A first opposite bent side 16' of the first bent section 12 is facing away from the second coil 20, and it electrically and physically connects the first opposite side 16 with the first upper side 17'. The first overlapping bent side 18' and the first opposite bent side 16' are provided as substantially straight lines and arranged substantially perpendicular to the first plane in which the first detection area 14 is arranged. The first upper bent side 17' is aligned substantially parallel to the first bent-side 13 in a direction parallel to the first plane. The first upper bent side 17' corresponds to the other partially overlapping side 117 of the first planar coil 110 shown at the left of Fig. 1A - only moved out of the first plane.

The three substantially straight sides 26, 27, and 28 of the second planar section 21 are provided by a lobe of the second coil 20 shown in Fig. 1C. The three sides 26, 27, and 28 are substantially identical to the opposite side 126, one of the partially overlapping sides 127, and to the overlapping side 128 of the second planar coil 120 at the left of Fig. 1A. The second detection area 24 is substantially rectangular and limited by said three substantially straight sides 26, 27, and 28 of the second planar section 21 and a second bent-side 23 marked by a dashed line in Fig. 1C. The second bent-side 23 may not provided by any substantial feature, e.g., a lobe, of the second coil 20, but may be provided at a bending of the second coil 20. The second bent-side 23 is arranged at the transition from the second planar section 21 to the second bent section 22. Also, the second bent-side 23 may be provided by an orthogonal projection of the second bent section 22 onto the second plane in which the second planar section 21 is arranged.

Fig. 1C shows that substantially all parts of the second bent section 22 of the second coil 20 are arranged within a second orthogonal plane. Thus, the second bent section 22 defines a second orthogonal area 25 of the second coil 20. The second orthogonal area 25 is limited by lobes of the second bent section 22 of the second coil 20 that are aligned substantially orthogonal to the second plane. The whole loop of the second coil 20 is provided by the second planar section 21 and the second bent section 22. Thus, the whole loop of the second coil 20 is arranged within the second planar plane and the second orthogonal plane.

The second bent section 22 comprises a second upper side 27' that is arranged at the opposite side of the second bent-side 23. A second overlapping bent side 28' of the second bent section 22 overlaps the first coil 10. The second overlapping bent side 28' electrically and physically connects the second overlapping side 28 with the second upper side 27'. A second opposite bent side 26' of the second bent section 22 is facing away from the first coil 10, and it electrically and physically connects the second opposite side 26 with the second upper side 27'. The second overlapping bent side 28' and the second opposite bent side 26' are provided as substantially straight lines and arranged substantially perpendicular to the second plane in which the second detection area 24 is arranged. The second upper bent side 27' is aligned substantially parallel to the second bent-side 23 in a direction parallel to the second plane. The second upper bent side 27' corresponds to the other partially overlapping side 127 of the second planar coil 120 shown at the left of Fig. 1A - only moved out of the second plane.

Both planar sections 11, 21 are provided substantially rectangular, similarly shaped and sized. The first overlapping side 18, the first opposite side 16, the second overlapping side 26, and the second opposite side 28 are all substantially arranged within the same planar plane, namely parallel to and spaced from each other. In particular, the first overlapping side 18 is spaced apart from the second overlapping side 28 by the overlapping area O. The first partially overlapping side 17 is substantially aligned with the second bent-side 23, while the second partially overlapping side 27 is substantially aligned with the first bent-side 13, all within substantially the same planar plane. The two planar sections 11 and 21 are substantially arranged in the same planar plane.

The two planar sections 11, 21 of the MRI-antenna 1 cover a total detection area 400 comprising the area that each individual planar section 11, 21 covers solely without the overlapped area O, namely the area between the first opposite side 16 and the second opposite side 26. The total detection area 400 may be part of a surface of a scan-volume 200 in which a sample or target may be arranged that the MRI-antenna 1 images. The total detection area 400 is the total planar area occupied by the two planar sections 11, 21 of the partially orthogonal MRI-antenna 1 minus the overlapped area O. The total detection area 400 of the partially orthogonal MRI-antenna 1 may be smaller than the total detection area 400 of the planar MRI-antenna 101.

As shown in Fig. 1A-1C, the first bent-side 13 is arranged in close vicinity of the second partially overlapping side 27, while the second bent-side 23 is arranged in close vicinity of the first partially overlapping side 17.

In the partially orthogonal MRI-antenna 1, one of the sides of the first coil 10 that connects the first overlapping side 18 with the first opposite side 16, namely the first upper side 17', is moved out of the first plane, thus forming the first bent section 12. Similarly, one of the sides of the second coil 20 that connects the second overlapping side 28 with the second opposite side 26, namely the second upper side 27', is moved out of the second plane, thus forming the second bent section 22. This reduces mutual interaction between parts of the two coils 10, 20 that are arranged within close vicinity of each other within the total detection area 400.

In comparison to the two coils 110, 120 of the planar MRI-antenna 1, the partially orthogonal single loop coils 10, 20 are modified by moving one of each of the partially overlapping sides 117, 127 out of the total detection area 400, thereby forming the height of the orthogonal area. This adds flexibility to the design of MRI-antennas and'/or arrays of such MRI-antennas in comparison to the traditional planar single loops with overlap where the overlap area and the total (planar) detection area are fully determined by the size of the coils (see left side of Fig. 1A).

The planar MRI-antenna 101 requires a fixed overlap based on the dimensions of the loops 110, 120 which also determine the total area 400 covered by the MRI-antenna 101. More flexibility in terms of overlap and total area 400 covered by the MRI-antenna 1 is added by using an orthogonal areas 15, 25.

One of the possibilities using the partially orthogonal coils, MRI-antennas, and/or resonators is to increase the coil density in arrays using overlap decoupling. Another possibility is to use a special case of the partially orthogonal coils, MRI-antennas, and/or resonators to place two coils over virtually the same area and thus, sensitivity to virtually the same volume. The sensitivity of the MRI-antenna 1 is defined by the alignment of the two detection areas 14 and 24.

In the MRI-antenna 1 shown at the right side of Fig. 1A, the first bent section 12 of the first coil 10 is arranged at the second partially overlapping side 27 of the second coil 20. The second bent section 22 of the second coil 20 is arranged at the first partially overlapping side 17 of the first coil 10. Thus, the two bent section 12, 22 are arranged at opposite sides of target area 400, corresponding to the total detection area of the MRI-antenna 1. Therefore, the two orthogonal area 15 and 25 are substantially parallel to each other and are spaced apart from each other by the whole length of the total detection area 400

**Fig. 2** shows a schematic representation of the planar MRI-antenna 101 at the left side and a schematic representation of an alternative partially orthogonal MRI-antenna 2 at the right side.

The planar MRI-antenna 101 shown in Fig. 2 substantially corresponds to the planar MRI-antenna 101 shown in Fig. 1A, shown in a slightly different style. The first planar coil 110 of the MRI-antenna 101 defines a first detection area 114 that partially overlaps a second detection area 124 defined by the second planar coil 120.

The partially orthogonal MRI-antenna 2 shown at the right side of Fig. 2 comprises two coils 10 and 20 that are similar to the two coils 10 and 20 shown in Fig. 1A. The first coil 10 comprises the first planar section 11 and the first bent section 12, as does the second coil 20 comprise the second planar section 21 and the second bent section 22. However, in the MRI-antenna 2, the two bent sections 12 and 22 are arranged at the same side of the total detection area of the MRI-antenna 2. Thus, the first orthogonal section 15 overlaps the second orthogonal section 25, because the two orthogonal sections 15, 25 are arranged in substantially the same orthogonal plane.

In the MRI-antenna 2, the first bent-side 13 is aligned with the second bent-side 23. The partially orthogonal MRI-antenna 2 provides another substitute for the planar MRI-antenna 101.

The MRI-antenna 101 shows a standard technique with overlap and no compensation for the decrease of size of two coils 110 and 120 that cover the target area which corresponds to the sum of the marked detection areas 114 and 124. The two overlapped single loop coils 10 and 20 of the MRI-antenna 2 also add flexibility to the overlap and dimensions due to the increased size in the orthogonal areas 15 and 25. This vertical and/or orthogonal part does not disturb the B1-fields that are responsible for stimulating the magnetic resonance of the sample/target. Moreover, in most MRI experiments, noise is sample dominated so the coil resistance is small compared to the sample resistance.

**Fig. 3** shows, at the left side, a schematic representation of a planar MRI-antenna 102 comprising a butterfly coil 130 and, at the right side, a partially orthogonal MRI-antenna 3 comprising a butterfly coil 30.

The planar MRI-antenna 102 comprises two substantially planar coils, namely a first planar coil 110 and the planar butterfly coil or figure-8 coil 130. The first planar coil 110 is implemented as a single loop coil and is substantially arranged in the centre of the planar butterfly coil 130 which completely overlaps the first coil 110.

The planar butterfly coil 130 comprises two wings with opposite current directions. In a first wing 131, the current direction causes constructive interference with the first planar coil 110 (indicated by the two '+' signs in Fig. 3). In a second wing 132, the current direction causes destructive interference with the first planar coil 110 (indicated by the '+' and the '-' sign in the shaded area of Fig. 3).

At the centre of the planar butterfly coil 130, namely at the transition between the two wings 131 and 132, an intersection 139 overlaps the first planar coil 110.

At the right side of Fig. 3, the partially orthogonal MRI-antenna 3 comprises a first coil 10 provided similar to the first coil of the MRI-antennas 1 and 2, and the butterfly coil or figure-8 coil 30 as its second coil. The butterfly coil 30 comprises a first wing 31 as its second planar section arranged in a substantially planar area which is substantially parallel to the first planar section 11 of the first coil 10. The first wing 31 defines a second detection area 34 that substantially overlaps the first detection area 14 of the first coil 10. The butterfly coil 30 further comprises a second wing 32 as its second bent section arranged in a substantially orthogonal area which is substantially parallel to the first bent section 12 of the first coil 10. The second wing 32 defines a second orthogonal area 35 that substantially overlaps the first orthogonal area 15 of the first coil 10.

In the two wings 31 and 32 of the butterfly coil 30, current flows in opposite directions. In the first wing 31, the current direction causes constructive interference with the first planar section 11 (indicated by the two '+' signs in Fig. 3). In the second wing 32, the current direction causes destructive interference with the first bent coil 12 (indicated by the '+' and the '-' sign in the shaded area of Fig. 3).

Similar to the second coil 20 of the MRI-antennas 1 and 2, also the butterfly coil 30 is bent at a second bent-side 33 providing a transition from the second planar section 31 to the second bent section 32. The butterfly coil 30 comprises an intersection 39 between its two wings 31, 32 arranged at the second bent-side 33. At the intersection 39, the current flow direction through the butterfly coil 30 changes.

The planar butterfly or figure-8 coil 130 shows inductive decoupling when placed substantially concentrically with the single loop coil 110. This has been used in previous studies as a quadrature pair to detect a full complex magnetization. Although quadrature detection is desired for increased performance, further SNR gain may be obtained by increasing in-phase signal detection prior to adding an element for quadrature detection. In-phase concentric coils subdivided into "lobes" generate H-fields in opposite direction for different lobes. This creates intrinsic H-field interferences with adjacent coils which reduce the sensitivity of the array.

By the partially bent coils used in the MRI-antenna 3, the performance of planar concentric arrays is improved, e.g. by reducing H-field destructive interferences when the coils are driven in-phase while focusing the sensitivity to the planar surface of the scan-volume 200. One aspect of the approach is to use only the part of the coil array where the two coils yield a constructive interference of the H-field. The part of the array with destructive interference may be placed in the orthogonal plane where the influence of the interference does not affect the signal reception which increases the detection efficiency as in the MRI-antenna 3. Thus, the challenging purpose of increasing SNR at a target depth is addressed. SNR at other target depths may be optimized by changing the size of the coils.

As shown at the left of Fig. 3, the direction of the current in the respective coil determines the direction of the H-field represented with plus or minus. The direction of the H-field varies during the phase cycle equally for a single loop and a butterfly. Therefore, stacking the first planar coil 110 with the planar butterfly coil 130 with the same phase will create constructive interference in one part of the coil array (namely in the part of the first wing 131 that is overlapped by the first planar coil 110) and destructive interference in the other part (namely the second wing 132 that is overlapped by the first planar coil 110). Therefore, the coils of the MRI-antenna 102 are sensitive on the surface of the scan-volume 200 except within the shaded area of destructive interference. Outside of this area, the H-fields of the two coils have constructive interference. However, the shaded area have reduced sensitivity due to the opposing H-fields and have an adverse contribution to the overall sensitivity of the array. This area disturbs and reduces the B1-fields as well. It is known to use the planar MRI-antenna 102 in quadrature to avoid H-field disturbances and to increase the sensitivity. However, this limits the pair to two coils 110, 130 to avoid disturbances.

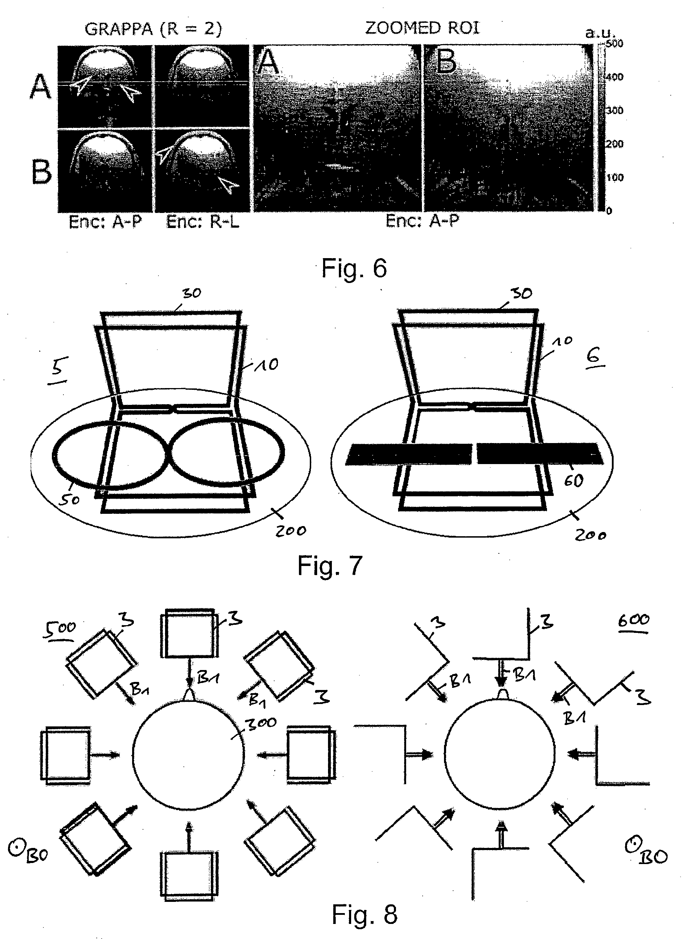

As shown at the right of Fig. 3, this limitation is overcome by the MRI-antenna 3. The two in-phase coils 10, 30 with no disturbances may achieve quadrature with a third coil which further increases sensitivity and efficiency (see Fig. 7). The third coil may be provided as a planar coil, e.g., as butterfly, as figure-8, as Helmholtz, as dipole and/or composite. For the two coils 10, 30 of the MRI-antenna 3, the constructive interference of the H-field are used to increase sensitivity and the destructive interference are orthogonal to that plane. Therefore, there are no disturbances in B1-fields.

The orthogonal areas 15 and 35 with opposing H-field directions may be used as active shielding in the orthogonal plane. The constructive interference at the overlapping two detection areas 14 and 34 shows high sensitivity to the surface of the scan-volume 200 and may be increased for enhanced B1-fields and more efficient use of planar physical space. Herein, the wings 31, 32 of the butterfly coil 30 may substantially comprise the same size as the two sections 11, 12 of the first coil 10. Thus, e.g. the second detection area 31 provided by the first wing may substantially have the same size as the first detection area 11 provided by the first planar section.

Namely, the sizes may only differ by at most 30%, preferably at most 15%, even more preferably at most 5%.

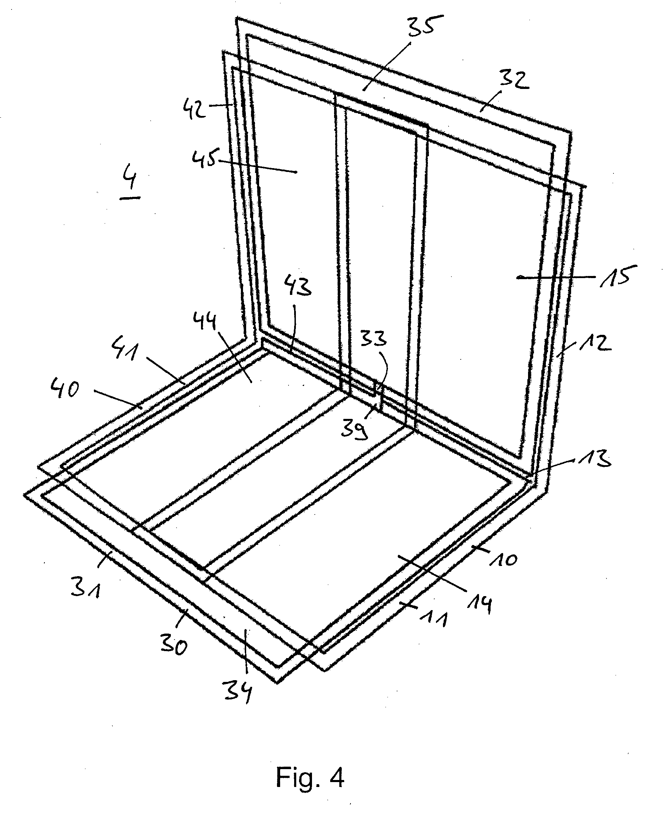

**Fig. 4** shows a schematic representation of a partially orthogonal MRI-antenna 4 comprising three coils. For increased efficiency, the single loop coil 10 as shown in Fig. 3 as part of the partially orthogonal MRI-antenna 3 is 'split' into more (here two) single loop coils having similar vertical parts and decoupled with overlap while maintaining the partially vertical butterfly or Figure-8 coil of the MRI-antenna 3.

The partially orthogonal MRI-antenna 4 comprises three coils. For increased efficiency, the MRI-antenna 4 may show the advantages of the MRI-antenna 2 and of the MRI-antenna 3. Similar to the MRI-antenna 2 shown at the right of Fig. 2, a first coil 10 partially overlaps a third coil 40, both implemented as single loop coils. The first and third coils 10 and 40 comprise a first and third planar section 11 and 41 and a first and third bent section 12 and 42. The first and third coils 10 and 40 are arranged as the first and second coil 10, 20 of the MRI-antenna 2 shown at the right of Fig. 2. Namely, the third coil 40 comprises a third bent-side 43 at a transition between a third detection area 44 and a third orthogonal area 45 of the third coil. The first, second, and third bent-sides 13, 33, and 43 overlap and are substantially aligned above each other.

The first and third coils 10 and 40 overlap with a butterfly coil 30, similar to the butterfly coil 30 of the MRI-antenna 3 shown at the right of Fig. 3. Here, the first detection area 14 and the third detection area 44 overlap with the second detection area 34 provided by the first butterfly wing of the butterfly coil 30 as areas of constructive interference. The first, second, and third bent sections 12, 32, and 42 may show destructive interference.

The implementation of the third coil 40 further improves the sensitivity of the MRI-antenna 4. Here, both the first and the third coils 10 and 40 may be driven with the same phase. They may also be driven in quadrature. However, quadrature may be better applied by the MRI-antennas 5 and 6 shown in Fig. 8.

Moreover, the first and third coils 10 and 40 may be taken as one element of an array and may be extended laterally (i.e. both, vertical and horizontal areas decoupled with overlap) and/or mirrored (i.e. two pairs with the vertical areas in front of each other and the horizontal areas decoupled with overlap).

In a performance comparison against planar approaches as in the MRI-antennas 101 and 102, the partially orthogonal MRI-antennas 1, 2, and 3 show a higher sensitivity. The compared arrays/MRI-antennas cover approximately the same planar area.

Measurements on the planar MRI-antenna 101 (see Fig. 1A and 2) show a geometric decoupling of the coil arrays measured in transmission of approximately -15 dB. Measurements on the partially MRI-antenna 1 (see Fig. 1A) show a geometric decoupling of the coil arrays measured in transmission of approximately -10 dB. The MRI experiments show an increase of SNR in the areas with greater distance to the planar area of the array when acquiring the data using the partially orthogonal coil pair (as in the partially orthogonal MRI-antenna 1) in comparison to single loop and the two loops with overlap (as in the planar MRI-antenna 101). This can also be seen in a profile taken through the center of the phantom. The SNR gains are obtained starting at a distance of 6 cm from the surface of the phantom and are observed until the far end of the phantom.

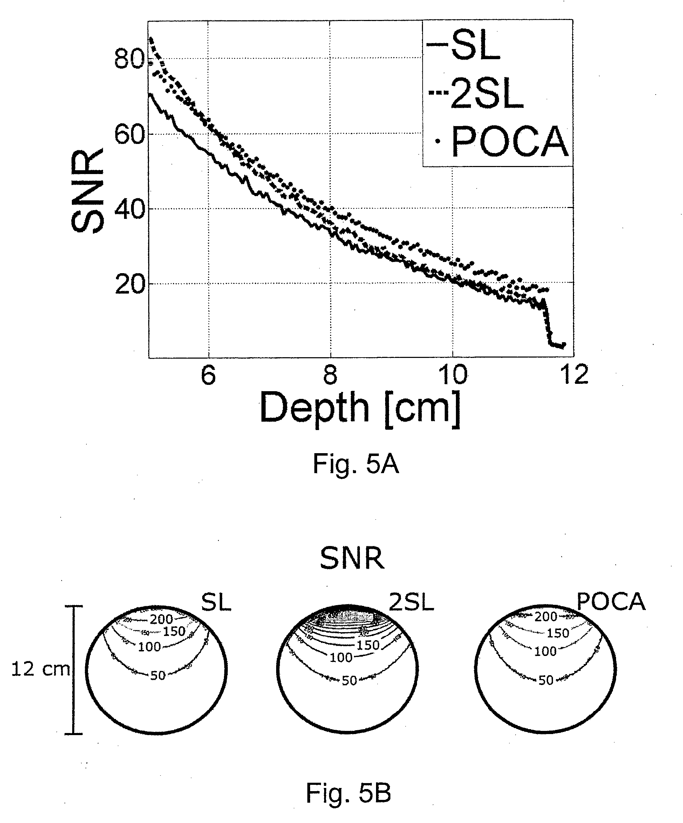

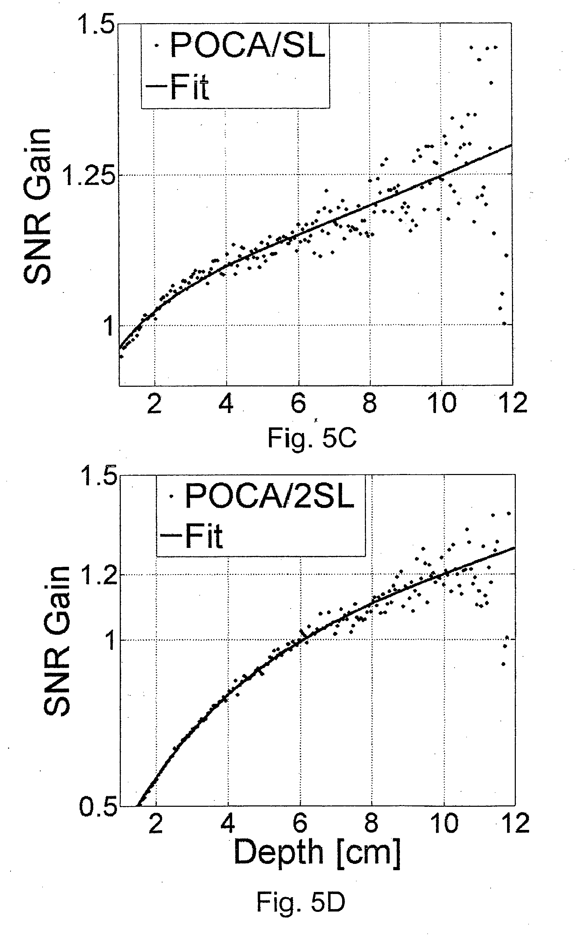

**Fig. 5** shows SNR maps and SNR ratios acquired from phantom MRI measurements.

**Fig. 5A** shows a plot of the signal-to-noise ratio of a single loop coil (abbreviated as 'SL'), of two planar single loop coils with overlap (abbreviated as '2SL') as in the MRI-antenna 101, and of a partially orthogonal coil array (abbreviated as 'POCA') as in the MRI-antenna 3. While the two planar single loop coils 2SL may show a slightly better SNR at the target surface and in smaller depths up to about 3 cm or 4 cm, an increase of SNR at the a larger target depth is shown using the partially orthogonal MRI-antenna 1.

**Fig. 5B** shows circular SNR maps of the different arrays. The increase of SNR with increasing depth is also shown in these SNR maps for SL, 2SL, and POCA.

**Fig. 5C and 5D** show profiles through the center acquired and fitted with a bi-exponential fit to estimate the gain.

SNR gains are yielded in the whole measured volume by the partially orthogonal array in comparison to the single loop (see Fig. 5C). In comparison to the two single loops with overlap gains are shown as the distance from the coil increases (see Fig. 5D). At a target distance of 10 cm from the MRI-antenna, namely from the planar plane, an approximate 1.25-fold SNR increase is shown when comparing the partially orthogonal coil pair POCA to the single loop SL and an approximate 1.2-fold when compared to the two single loops array 2SL using bi-exponential fits. Noise correlation of the coils are 20% for the two single loops with overlap and 13% for the partially orthogonal coil pair.

In vivo, the geometric decoupling due to the load of the sample is approximately -16 dB for the two single loop coils with overlap planar array 2SL and -13 dB for the partially orthogonal array POCA. For the planar MRI-antenna 101, the noise correlation is 31%, and for the partially orthogonal MRI-antenna 1 it is 13%.

**Fig. 6** shows in vivo brain scans of a volunteer with GRAPPA as a parallel imaging data acquisition. GRAPPA is an abbreviation for GeneRalized Autocalibrating Partial Parallel Acquisition. The images are acquired using GRAPPA 18 as parallel imaging strategy with a reduction factor of 2. Therein, artifacts are shown in the center of a brain as sample by using different direction for phase encoding.

Therein, more pronounced artifacts are shown when using the planar MRI-antenna 101 in the anterior-posterior direction for phase encoding up to an approximately target distance of the coils. The images taken with the planar MRI-antenna 101 are marked by 'A' in Fig. 6. The artifacts present when using with the planar MRI-antenna 101 are marked by arrows (see Fig. 6, A, Enc: A-P).

The images taken with the partially orthogonal MRI-antenna 1 are marked by 'B' in Fig. 6. Artifacts are more apparent when using the right-left direction used for phase encoding for the partially vertical coil array 1 (see Fig. 6, B, Enc: R-L). The reduction in artifacts with higher signal using the partially orthogonal MRI-antenna 1 (B) is even more prominent in the zoomed region of interest (ROI). Therefore, the partially orthogonal MRI-antennas are preferably used in an anterior-posterior direction for phase encoding.

**Fig. 7** shows a schematic representation of two partially orthogonal MRI-antennas 5 and 6 for quadrature signal detection. Other planar and/or orthogonal coils including but not limited to butterfly, Helmholtz, and composite may be provided additionally or alternatively.

At the left side of Fig. 7, a partially orthogonal MRI-antenna 5 is shown that - similar to the MRI-antenna 3 shown in Fig. 3 - comprises a first coil 10 and a butterfly coil 30 as its second coil. Each of the two coils 10, 30 comprises a planar section and a bent section, respectively, as described with reference to Fig. 3. Additionally, the MRI-antenna 5 comprises a further butterfly coil 50, namely a planar butterfly coil, of which both wings are substantially arranged within the planar plane.

At the right side of Fig. 7, a partially orthogonal MRI-antenna 6 is shown that - similar to the MRI-antenna 3 shown in Fig. 3 - comprises a first coil 10 and a butterfly coil 30 as its second coil. Each of the two coils 10, 30 comprises a planar section and a bent section, respectively, as described with reference to Fig. 3. Additionally, the MRI-antenna 6 comprises a dipole antenna 60 arranged within the planar plane.

The further butterfly coil 50 of the MRI-antenna 5 and the dipole antenna 60 of the MRI-antenna 6 are arranged over the surface of the scan-volume 200 and substantially parallel to the first and second detection areas 14, 34 of the two coils 10, 30 (see also Fig. 3).

Either of the two MRI-antennas 5, 6 may be used for quadrature signal detection using three coils with reduced H-field destructive interference and reduced B1-field disturbances. Quadrature may be achieved with such a third element which increases sensitivity. In planar designs (as in the planar MRI-antenna 102 shown in Fig. 3), H-field destructive interferences and B1-field disturbances are unavoidable when stacking three coils, even if one of them is in quadrature. This is because two coils remain in-phase.

In the MRI-antenna 5, quadrature is achieved with the further figure-8 or butterfly coil 50 without H-field destructive interference or B1-field disturbances while increasing the detection with the quadrature element.

In the MRI-antenna 6, quadrature may be achieved using the dipole antenna 60 but the three coils/elements may also be driven using the same phase.

Combinations of the partially vertical coils, the dipole and the butterfly may be implemented in further embodiments.

**Fig. 8** shows a schematic representation of two arrays 500, 600 of partially orthogonal MRI-antennas 3. The two arrays 500, 600 are arranged around a sample 300, e.g., the head of a person for a brain scan. The direction of the constant B0-field for the MRI is indicated and points through the centre of the sample 300 towards the viewer of Fig. 8, e.g. from the feet to the head of a patient shown schematically in Fig. 8 with its nose facing upwards. The directions of the B1-fields inducing the magnetic resonance are also shown by the arrows pointing away from the MRI-antennas 3. The B1-fields are arranged substantially perpendicular to the B0-field and point towards the sample 300, e.g. to the head of the patient.

The sample 300 is surrounded by a plurality of partially orthogonal MRI-antennas 3, one of which is shown in Fig. 3. All of the MRI-antennas 3 are arranged so that their detection areas 14, 34 face the sample 300. Thus, the sensitivity of both coils 10, 30 of the MRI-antennas 3 points and/or is directed towards the sample 300. A normal on each of the detection areas 14, 34 of the MRI-antennas is indicated as an arrow and points from the respective detection area 14, 34 towards the sample 300, e.g. the head of the patient, e.g. towards the centre of the sample 300.

The orthogonal areas 15, 35 of the two coils 10, 30 of the two arrays 500, 600 are arranged differently. In the first array 500 shown at the left of Fig. 8, the B1-fields generated by the orthogonal areas 15, 35 are aligned parallel to the B0-field.. In the second array 600 shown at the right of Fig. 8, the B1-fields generated by the orthogonal areas 15, 35 are substantially perpendicular to the B0-field.

The coil pairs of the MRI-antennas 3 are taken as an element of the array 500 and 600. Both coils 10, 30 of each MRI-antenna 3 have sensitivity over the desired area since they both create a B1-field in the direction of the patient or sample 300. This may increase the SNR and efficiency of volumetric acquisitions and improves the efficiency of parallel imaging techniques which reduce scanning times.

The first array 500 (wherein the B1-fields generated by the orthogonal areas 15, 35 are aligned perpendicular to B0) may reduce the SAR and E-field which is different to the purpose of increasing H-field sensitivity. Herein, the orthogonal areas 15, 35 may provide shielding. In the second array 600 (wherein the B1-fields generated by the orthogonal areas 15, 35 are perpendicular to B0), the arrangement may increase sensitivity over the magnetization and may be useful for localization purposes.

Instead of the MRI-antennas 3, the two arrays 500 and 600 may also be implemented with a plurality of the MRI-antennas 1, 2, 3, 4, 5, and/or 6. The arrays may also comprise a mix of these MRI-antennas.

In the partially orthogonal MRI-antennas 1, 2, 3, 4, 5, 6 and in the arrays 500 and 600, parts of the coils are bent, in particular in an orthogonal plane. These bent sections of the coils are not used primarily for signal detection. The bent sections of the coils may be used to add flexibility to the design of the coils of the respective MRI-antennas and/or arrays. However, all the elements of the partially orthogonal MRI-antennas may have sensitivity to the signal, at least partially. This is distinctive from previous approaches that employed entire elements virtually insensitive to the signal to reduce E-fields.

By the partially orthogonal arrangement of the MRI-antennas, the physical planar space placed over the sampled volume may be optimized. These partially orthogonal MRI-antennas may reduce the H-field destructive interferences of the coils in the plane with maximum sensitivity to the MRI signal while using constructive interference of the coils in this plane.. An increase in |B1-|norm may be found in respect to the reference single loop and the common two loop array with overlap driven in-phase. This may be achieved despite the trade-off of increased mutual coupling between coils of the partially orthogonal coil pair in respect to the two loops with overlap in simulations and/or measurements.

Increasing penetration depth is a well-known challenge in MRI. This is because subdividing the planar area into smaller coils increases peripheral SNR but the gains decrease as the distance from the array increases. Based on the novel concept of partially orthogonal resonators, partially orthogonal MRI-antennas show an increase in SNR at the target depth. The gain may be approximately 20% SNR compared to two single loops with overlap and approximately 25% compared to a reference single loop optimized for the target depth. The gain occurs despite reducing the sensitivity of the coils partially. This may be because the noise is sample dominated.

Thus, the invention may present an advantage to traditional methods considering the difficulties to enhance SNR at this depth. SNR in the periphery may be reduced compared to common approaches. SNR may be achieved at the periphery by using arrays 500, 600 of the proposed MRI-antennas 1, 2, 3, 4, 5, and/or 6.

Using in vivo brain scans, parallel imaging performance may be assessed. For the described strategy GRAPPA, an advantage may be achieved when using the anterior-posterior direction to encode the phase. A drawback may occur in the left-right direction for phase encoding. However, this drawback may be overcome by arranging further coils adjacent to the arrays 500, 600.

An array 500, 600 of the partially orthogonal coil pairs as in the MRI-antennas 1, 2, 3, 4, 5, 6 may increase the local SNR at target regions compared to common arrays with multitude of planar lateral coils. The arrays 500, 600 may find applications in both brain and body MRI.

The MRI-antennas 1, 2, 3, 4, 5, and 6 are shown schematically in the figures and may comprise further elements, e.g. electrical connections and/or contacts to further components. The partially orthogonal MRI-antennas 1, 2, 3, 4, 5, and 6 comprise coils 10, 20, 30, 40 which are aligned partially planar and partially orthogonal, respectively.

**List of Reference Numerals**

| | |
|---|---|
| 1,2,3 | partially orthogonal MRI-antenna |
| 4,5,6 | partially orthogonal MRI-antenna |
| 10 | first coil |
| 11 | first planar section |
| 12 | first bent section |
| 13 | first bent-side |
| 14 | first detection area |
| 15 | first orthogonal area |
| 16 | first opposite side |
| 16' | first opposite bent side |
| 17 | first partially overlapping side |
| 17' | first upper side |
| 18 | first overlapping side |
| 18' | first overlapping bent side |
| 20 | second coil |
| 21 | second planar section |
| 22 | second bent section |
| 23 | second bent-side |
| 24 | second detection area |
| 25 | second orthogonal area |
| 26 | second opposite side |
| 26' | second opposite bent side |
| 27 | second partially overlapping side |
| 27' | second upper side |
| 28 | second overlapping side |
| 28' | second overlapping bent side |
| 30 | butterfly coil |
| 31 | second planar section |
| 32 | second bent section |
| 33 | second bent-side |
| 34 | second detection area |
| 35 | second orthogonal area |
| 39 | intersection |
| 40 | third coil |
| 41 | third planar section |
| 42 | third bent section |
| 43 | third bent-side |
| 44 | third detection area |
| 45 | third orthogonal area |
| 50 | butterfly coil |
| 60 | dipole antenna |
| 101 | planar MRI-antenna |
| 102 | planar MRI-antenna |
| 110 | first planar coil |
| 114 | first detection area |
| 117 | partially overlapping side |
| 118 | first overlapping side |
| 120 | second planar coil |
| 124 | second detection area |

| | |
|---|---|
| 127 | partially overlapping side |
| 128 | second overlapping side |
| 130 | planar butterfly coil |
| 131 | first wing |
| 132 | second wing |
| 139 | intersection |
| 200 | surface of scan-volume |
| 300 | sample |
| 400 | total detection area |
| 500, 600 | array of partially orthogonal MRI-antennas |
| O | overlapped area |

**Claims**

1. Magnetic resonance imaging - antenna (1; 2; 3; 4; 5; 6) comprising:

   - a first coil (10) comprising a first planar section (11) defining a first detection area (14), wherein the first planar section (11) is arranged within a first plane, and
   - a second coil (20; 30) comprising a second planar section (21; 31) defining a second detection area (24; 34), wherein the second planar section (21; 31) is arranged within a second plane;

   wherein the first coil (10) comprises a first bent section (12) that is bent out of the first plane of the first planar section (11).

2. The MRI-antenna (1; 2; 3; 4; 5; 6) according to claim 1, wherein the first bent section (12) at least partially adjoins and/or overlaps the second detection area (24; 34).

3. The MRI-antenna (1; 2; 3; 4; 5; 6) according to claim 1 or 2, wherein the first planar section (12) at least partially overlaps the second planar section (21; 31) so that the first detection area (14) at least partially overlaps the second detection area (24; 34).

4. The MRI-antenna (1; 2; 3; 4; 5; 6) according to any of the preceding claims, wherein the first bent section (12) is bent substantially orthogonal to the first planar section (11).

5. The MRI-antenna (1; 2; 3; 4; 5; 6) according to any of the preceding claims, wherein the second coil (20; 30) comprises a second bent section (22; 32) that is bent out of the second plane of the second planar section (21; 31).

6. The MRI-antenna (1; 2; 3; 4; 5; 6) according to any of the preceding claims, wherein, in a orthogonal projection onto the first plane, the first bent section (12) is spaced from the second planar section (21; 31) less than 2 cm.

7. The MRI-antenna (1; 2; 3; 4; 5; 6) according to any of the preceding claims, wherein the first bent section (12) is arranged at an area of destructive interference originating from a close proximity of the first coil (10) and the second coil (20; 30).

8. The MRI-antenna (1; 2; 3; 4; 5; 6) according to any of the preceding claims, wherein

    - the first bent section (12) of the first coil (10) defines a first substantially orthogonal area (15) of the first coil (10) arranged at a first bent-side (13) of the first detection area (14),
    - the second coil (20; 30) comprises a second bent section (22; 32) that is bent out of the second plane of the second planar section (21; 31), and
    - the second bent section (22; 32) defines a second substantially orthogonal area (25; 35) of the second coil (20; 30) arranged at a second bent-side (23; 33) of the second detection area (24; 34).

9. The MRI-antenna (1) according to claim 8, wherein the first bent-side (12) is at least partially adjoining the second detection area (24; 34) at a side opposite of the second bent-side (23; 33) and/or wherein the second bent-side (23; 33) is at least partially adjoining the first detection area (14) at a side opposite of the first bent-side (13).

10. The MRI-antenna (2; 3; 4; 5; 6) according to claim 8, wherein the first bent-side (13) is substantially aligned with the second bent-side (23; 33) so that the first detection area (14) at least partially overlaps the second detection area (24; 34) and the first orthogonal area (15) at least partially overlaps the second orthogonal area (25; 35).

11. The MRI-antenna (1; 2) according to any of claims 8 to 10, wherein the first coil (10) is provided as a single loop coil and the second coil (20) is provided as a single loop coil.

12. The MRI-antenna (3; 4; 5; 6) according to any of claims 8 to 10, wherein

    - the first coil (10) is provided as a first single-loop coil,
    - the second coil (30) is provided as a butterfly coil, and
    - the second bent-side (33) is arranged at the intersection (39) of the butterfly coil (30) so that a planar wing of the butterfly coil (30) is arranged as the second planar section (31) and a bent wing of the butterfly coil (30) is arranged as the second bent section (32).

13. The MRI-antenna (4) according to claim 12, wherein

    - a third coil (40) is provided as a single-loop coil comprising a third planar section (41) defining a third detection area (44), wherein the third planar section (41) is arranged within a third plane;
    - the third coil (40) comprises a third bent section (42) that is bent out of the third plane of the third planar section (41), and
    - the third bent section (42) defines a third substantially orthogonal area (45) of the third coil (40) arranged at a third bent-side (43) of the third detection area (44),

wherein the third bent-side (43) is arranged parallel to the first bent-side (13) and to the second bent-side (33) so that the third detection area (44) at least partially overlaps the first detection area (14) and the second detection area (34).

14. A plurality of the MRI-antennas (1; 2; 3; 4; 5; 6) according to any of the preceding claims arranged in an array (500; 600).

15. Method for providing magnetic resonance images by detecting magnetic resonance signals by at least one MRI-antenna (1; 2; 3; 4; 5; 6), comprising the steps:

    - arranging a first planar section (11) defining a first detection area (14) of a first coil (10) of the MRI-antenna (1; 2; 3; 4; 5; 6) within a first plane,
    - arranging a second planar section (21; 31) defining a second detection area (24; 34) of a second coil (20; 30) of the MRI-antenna (1; 2; 3; 4; 5; 6) within a second plane; and
    - arranging a first bent section (12) of the first coil (1) so that the bent section (12) is bent out of the first plane of the first planar section (11).

Fig. 1A

Fig. 1B

Fig. 1C

**Fig. 2**

**Fig. 3**

Fig. 4

Fig. 5A

Fig. 5B

Fig. 5C

Fig. 5D

GRAPPA (R = 2)    ZOOMED ROI    a.u.

A    Enc: A-P    Enc: R-L

B

Enc: A-P    Enc: R-L    Enc: A-P

## Fig. 6

## Fig. 7

## Fig. 8

Europäisches
Patentamt

European
Patent Office

Office européen
des brevets

# EUROPEAN SEARCH REPORT

Application Number

EP 16 00 1855

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | JORGE CHACON-CALDERA ET AL: "Partially orthogonal resonators for magnetic resonance imaging", SCIENTIFIC REPORTS, vol. 7, 10 February 2017 (2017-02-10), page 42347, XP055351523, DOI: 10.1038/srep42347 * the whole document * | 1-15 | INV. G01R33/3415 ADD. G01R33/36 |
| X | US 2014/239953 A1 (LUONG MICHEL [FR] ET AL) 28 August 2014 (2014-08-28) * paragraph [0071] - paragraph [0105] * * figures 2a-4 * | 1,2,4, 6-11,14, 15 | |
| X | US 5 370 118 A (VIJ KAMAL [US] ET AL) 6 December 1994 (1994-12-06) * column 6, lines 22-61 * * figure 3a * | 1-15 | |
| X | US 5 519 321 A (HAGEN JUERGEN [DE] ET AL) 21 May 1996 (1996-05-21) * column 3, line 43 - column 5, line 53 * * figure 8 * | 1-11,14, 15 | TECHNICAL FIELDS SEARCHED (IPC) G01R |
| X | US 7 365 542 B1 (ROHLING KENNETH W [US] ET AL) 29 April 2008 (2008-04-29) * column 4, lines 7-45 * * figures 2, 3 * | 1-11,14, 15 | |
| X | US 2009/124889 A1 (GUAN YIPING [US] ET AL) 14 May 2009 (2009-05-14) * paragraph [0026] - paragraph [0028] * * figures 2-4 * | 1-15 | |

-/--

The present search report has been drawn up for all claims

| Place of search | Date of completion of the search | Examiner |
|---|---|---|
| Munich | 3 March 2017 | Streif, Jörg Ulrich |

Europäisches
Patentamt

European
Patent Office

Office européen
des brevets

**EUROPEAN SEARCH REPORT**

Application Number

EP 16 00 1855

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 750 653 B1 (ZOU MARK X [US] ET AL) 15 June 2004 (2004-06-15) * column 3, lines 41-55 * * figure 6 * ----- | 1-4,6,7, 14,15 | |
| X | US 5 548 218 A (LU DONGFENG [US]) 20 August 1996 (1996-08-20) * column 3, line 50 - column 5, line 13 * * figures 1-4 * ----- | 1-15 | |

TECHNICAL FIELDS
SEARCHED      (IPC)

The present search report has been drawn up for all claims

| Place of search | Date of completion of the search | Examiner |
|---|---|---|
| Munich | 3 March 2017 | Streif, Jörg Ulrich |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 16 00 1855

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2017

| Patent document cited in search report | | Publication date | Patent family member(s) | | Publication date |
|---|---|---|---|---|---|
| US 2014239953 | A1 | 28-08-2014 | EP 2772771 A1<br>FR 3002699 A1<br>US 2014239953 A1 | | 03-09-2014<br>29-08-2014<br>28-08-2014 |
| US 5370118 | A | 06-12-1994 | NONE | | |
| US 5519321 | A | 21-05-1996 | DE 4318134 A1<br>JP H0795973 A<br>US 5519321 A | | 08-12-1994<br>11-04-1995<br>21-05-1996 |
| US 7365542 | B1 | 29-04-2008 | NONE | | |
| US 2009124889 | A1 | 14-05-2009 | NONE | | |
| US 6750653 | B1 | 15-06-2004 | NONE | | |
| US 5548218 | A | 20-08-1996 | NONE | | |

EPO FORM P0459

For more details about this annex : see Official Journal of the European Patent Office, No. 12/82